# DEMANDE DE BREVET EUROPEEN

(11) **EP 4 817 837 A1**
(43) Date de publication de la demande: **07.10.2026**
(21) Numéro de dépôt: 26170276.5
(22) Date de dépôt: 01.04.2026
(51) Int. Cl.: B29B 17/02, H10F 19/80, B29L 31/34

(54) **PROCEDE DE SEPARATION CHIMIQUE DES MATERIAUX METALLIQUES ET DES POLYMERES DE PANNEAUX SOLAIRES PHOTOVOLTAÏQUES**

(30) Priorité: 03.04.2025 FR 2503521
(71) Demandeur: Commissariat à l'Energie Atomique et aux Energies Alternatives, 75015 Paris (FR)
(72) Inventeur: DUWALD, Romain, 38054 GRENOBLE (FR)
(74) Mandataire: Gevers & Orès

(57) **Abrégé**

L'invention concerne le domaine de la séparation physique et le recyclage des composants constitutifs d'un module photovoltaïque à base de silicium. En particulier, l'invention a pour but de séparer les polymères des métaux provenant de cellules solaires en silicium, sans dégradation ni des polymères ni des métaux.

La séparation repose sur une séparation physique des différents matériaux en utilisant leur densité.

## Description

### Domaine technique de l'invention

L'invention concerne le domaine de la séparation physique et le recyclage des éléments constitutifs d'un module photovoltaïque à base de silicium. En particulier, l'invention a pour but de séparer les polymères des métaux provenant de cellules solaires en silicium, sans dégradation ni des polymères ni des métaux.

La séparation repose sur une séparation physique des différents matériaux en utilisant leur densité.

### Arrière-plan technique

Les énergies dites renouvelables émergent comme une solution viable à la production d'une énergie décarbonée. Parmi ces énergies renouvelables, l'énergie solaire est produite via la conversion des rayonnements solaires en électricité dans les panneaux solaires photovoltaïques. Lorsqu'un panneau solaire arrive en fin de vie, il doit être démantelé pour être recyclé. Il convient donc de limiter autant que possible l'impact sur l'environnement du recyclage des panneaux photovoltaïques en fin de vie.

Les panneaux solaires photovoltaïques au silicium cristallin sont constitués d'une superposition de couches comme montré en [**Erreur ! Source du renvoi introuvable**.]. Une plaque de verre en face avant permet de protéger les cellules des intempéries. La face ou couche arrière est une feuille polymère multicouche, intégrant généralement une feuille de polymère fluoré (le poly(fluorure de vinyle) ou PVF, le poly(fluorure de vinylidène) ou PVDF, etc.) et d'autres feuilles polymères telles que du polyéthylène (PE) ou le polyéthylène téréphtalate (PET). Les cellules solaires en silicium sont encapsulées dans un polymère réticulé. L'encapsulant majoritairement rencontré dans les panneaux est l'EVA ou le poly(éthylène-acétate de vinyle).

L'EVA est majoritairement utilisé puisqu'il permet de garantir la bonne intégrité des panneaux dans le temps, leur offrant une grande résistance aux intempéries, à l'humidité et aux variations de températures.

Ce polymère est initialement un thermoplastique, il peut donc être fondu pour être mis en forme lors de la fabrication d'un panneau. L'EVA est utilisé en films, de formulation chimique commerciale intégrant des agents de réticulations, et des agents d'adhésion, généralement des organosilanes, permettant d'assurer une liaison chimique forte entre le verre et l'EVA d'une part, et entre les cellules solaires et l'EVA d'autre part. Un premier film d'encapsulant est placé entre la plaque de verre en face avant et les cellules solaires en silicium (c-Si), et un second film est placé entre la face arrière des cellules solaires et la couche arrière du panneau ou backsheet en anglais. Lors de la fabrication de panneaux, les différentes couches sont pressées à chaud (laminage), permettant dans un même temps la fusion des films d'EVA pour encapsuler les cellules et lier les différentes couches, et l'activation des agents de réticulations et d'adhésion par la chaleur. Les agents de réticulation permettent de transformer les chaines linéaires d'EVA en un réseau tridimensionnel dit « réticulé ». L'EVA initial sous sa forme linéaire est un thermoplastique, donc fongible. Une fois réticulé, l'EVA devient un polymère thermodur. Ainsi, la forme réticulée de l'encapsulant ne lui permet plus d'être fondu, et rend la délamination des différentes couches d'un module difficile. L'EVA réticulé est considéré non recyclable. Les agents de liaisons organosilylés assurent la tenue de l'EVA au verre et aux cellules via la création de liaisons covalentes fortes, ce qui rend difficile la séparation des différents matériaux d'intérêt (verre, cellule silicium, argent, cuivre, etc.). La valeur monétaire d'un panneau en fin de vie est essentiellement centrée sur les métaux contenus dans le panneau (Ag, Cu, Si, etc). Pour atteindre ces métaux, les polymères sont généralement éliminés par une étape de pyrolyse, énergivore et potentiellement polluante (étape émettrice de CO₂, de composés fluorés) selon la nature des polymères présents dans le panneau (polymères fluorés notamment).

Plusieurs techniques ont été proposées pour recycler et séparer les composants des modules photovoltaïques à base de silicium.

La demande de brevet CN113976597 A décrit un procédé à faible consommation d'énergie permettant de séparer et de recycler tous les composants d'un module photovoltaïque. Dans ces travaux, les matériaux polymères et métalliques d'un panneau solaire sont séparés par voie chimique en utilisant un solvant organique. Les solvants rapportés dans la demande de brevet font usage de solvants halogénés tels que le trichloroéthane et le dichlorobenzène, particulièrement toxiques et environnementalement défavorables. De plus, le procédé décrit permet de séparer la couche arrière ou backsheet de l'ensemble encapsulant + cellules, mais ne permet pas de séparer les cellules de l'encapsulant (EVA). L'encapsulant est éliminé par un procédé de pyrolyse qui nuit au bilan énergétique du procédé.

J. Lee et al. (Waste Management vol. 190 (2024), pages 122-130), ont étudié la délamination chimique d'un panneau en utilisant différents solvants organiques : toluène, D-limonène et un solvant à eutectique profond (DES). Dans ces travaux, la couche arrière (ou backsheet) et le verre sont séparés facilement du reste du panneau (encapsulant + cellules). Le solvant organique est chauffé à 90 °C pour permettre un gonflement de l'encapsulant et une séparation partielle des cellules et de l'encapsulant (jusqu'à 95 % d'élimination de l'encapsulant sur des fractions tamisées à 1 mm dans le cas du D-limonène). Néanmoins, pour les fractions d'une taille supérieure à 1 mm, les fragments de cellules sont liés à l'encapsulant et à la couche arrière (ou backsheet) et ne peuvent pas être valorisés sans une étape de pyrolyse supplémentaire.

Dans S. He et al. (Separation and Purification Technology, vol. 359 (2025),130682*),* les différents matériaux d'un panneau solaire sont séparés par voie chimique en utilisant de l'éthanol et du carbonate de sodium (Na₂CO₃) en phase aqueuse. La séparation est réalisée en deux étapes. Dans la première étape, un morceau de panneau d'une taille de 30 x 30 mm est placé dans un réacteur solvothermal. De l'éthanol anhydre est ajouté puis le réacteur est monté à une température de 200°C pour une durée allant de 5 à 75 minutes. Cette étape permet de séparer la couche arrière ou backsheet et l'électrode d'aluminium située en face arrière de la cellule solaire. Dans un second temps, l'éthanol est remplacé par une solution aqueuse de carbonate de sodium à une concentration comprise entre 0,2 M et 0,5 M. Le réacteur est à nouveau monté à une température comprise entre 160°C et 200°C pour une durée comprise entre 60 et 120 minutes. Cette seconde étape permet de séparer l'encapsulant et les grilles d'argent de la cellule en silicium. Ces travaux permettent une bonne séparation des matériaux, mais ne sont aujourd'hui pas envisageable à grande échelle. De plus, le travail à haute température nécessite de fournir beaucoup d'énergie au système, et de travailler dans un réacteur capable de tenir une pression élevée.

Il existe donc un réel besoin de disposer d'un procédé permettant de séparer et de recycler tous les composants constitutifs d'un module photovoltaïque à base de silicium, notamment pour séparer les polymères des métaux provenant de cellules solaires en silicium, sans dégradation ni des polymères ni des métaux.

En particulier, il existe un réel besoin de disposer d'un procédé tel que décrit ci-dessus, permettant de séparer la couche arrière (ou backsheet en anglais) pour ne pas générer de polluants fluorés.

### Résumé de l'invention

La présente invention a précisément pour but de répondre à ces besoins, en fournissant un procédé de séparation des métaux et des polymères de l'encapsulant d'un panneau solaire photovoltaïque, caractérisé en ce qu'il comporte les étapes suivantes :
**a)** Préparer un mélange de solvants dont
   - l'un des deux solvants est une solution aqueuse basique ayant un pH compris entre 8 et 14, et
   - l'autre au moins un solvant organique miscible à l'eau choisi parmi
      - les alcools primaires de formule R-CH₂OH avec R représentant un groupe alkyle comportant 1 à 4 atomes de carbone,
      - les alcools secondaires de formule R₀-CHOH-R₁ avec R₀ et R₁, identiques ou différents, représentant groupe alkyle comportant 1 à 3 atomes de carbone,
      - les diols de formule HOCH₂-(CHR₂)ₙ-CH₂OH avec n=1, 2, 3 et R₂ représentant un atome d'hydrogène ou un groupe alkyle comportant 1 à 3 atomes de carbone,
      - les diols de formule HOCH₂-(CH₂)ₘ-C(OH)R₄R₃ avec m=0 et 1 et R₃ et R₄, identiques ou différents, représentant un atome d'hydrogène, un groupe alkyle comportant 1 à 3 atomes de carbone,
      - les triols de formule HOCH₂-(CH₂)ₓ-C(OH)R₅-CH₂OH avec x= 0, 1, et R₅ représentant un atome d'hydrogène ou un groupe alkyle comportant 1 à 3 atomes de carbone,
      - les cétones de formule R₆-CO-R₇ avec R₆ et R₇, identiques ou différents, représentent un groupe alkyle comportant 1 à 3 atomes de carbone,
      - les nitriles de formule R₇-CN avec R₇ représentant un groupe alkyle comportant 1 à 3 atomes de carbone,
      et leur mélange ;
**b)** Ajouter les débris solides sous forme de poudre d'un panneau solaire photovoltaïque, contenant des cellules en silicium, un encapsulant polymère et potentiellement une fraction des polymères du panneau ou couche arrière polymère ou backsheet en anglais, au mélange de solvants préparé à l'étape **a)** ;
**c)** Agiter le mélange obtenu de l'étape **b)** à une température comprise entre 20 et 100 °C, de préférence à une température comprise entre 40 et 80 °C, par exemple 60 °C ;
**d)** Séparer les différents éléments une fois l'encapsulant décollé des cellules, et de la couche arrière ou backsheet en anglais.

Le procédé de l'invention permet de séparer les polymères des métaux provenant de cellules solaires sans dégrader ni les polymères ni les métaux. La séparation chimique des composants de panneaux solaires en voie liquide peut être appliquée à différentes poudres provenant de la délamination d'un panneau solaire photovoltaïque. Par délamination, on entend la séparation de la plaque de verre en face avant du reste des matériaux (encapsulant, cellules, couche arrière (ou backsheet en anglais)). Un mélange de poudre peut être obtenu avec différentes méthodes de délamination, comme par exemple, le ponçage ou le sciage par un fil diamanté. La présente invention permet d'accéder aux métaux sans pyrolyser les polymères.

Le procédé de l'invention se différentie des procédés décrits dans l'état de l'art par :
- La séparation des matériaux constitutifs d'un panneau solaire par voie chimique en utilisant un mélange de solvants formé par deux solvants miscibles dont l'un des deux solvants est l'eau contenant un sel alcalin, et l'autre solvant un solvant organique.
- Il permet de séparer les différents éléments par décollement des métaux de la cellule solaire, notamment en silicium, de l'encapsulant polymère, et de la couche arrière ou backsheet.
- Il permet dans le même temps de séparer par densité les différents éléments : les éléments lourds, notamment les métaux, décantent en fond de réacteur lorsqu'ils sont décollés de l'encapsulant. L'encapsulant de densité d < 1 se trouve en surface de la phase liquide.

L'invention a également pour objet l'utilisation d'un procédé selon l'invention pour le recyclage des panneaux solaires photovoltaïques.

### Brève description des figures

D'autres caractéristiques et avantages de l'invention apparaitront au cours de la lecture de la description détaillée qui va suivre pour la compréhension de laquelle on se reportera aux dessins annexés dans lesquels :
[Fig.1] représente un schéma structurel d'un panneau solaire photovoltaïque.
[Fig.2] représente les différentes étapes de ponçage d'un panneau solaire à partir de la face arrière constituée de couche arrière ou backsheet polymère.
[Fig.3] représente (gauche) un réacteur double enveloppe au début de l'étape de séparation chimique des matériaux contenant une suspension de poudre composée de polymère d'encapsulant et de poudre de cellules solaires en silicium composée de silicium (Si), d'argent (Ag), d'aluminium (AI) et de cuivre (Cu), et (droite) un réacteur double enveloppe en après l'étape de séparation chimique des matériaux, avec au fond du réacteur la poudre en mélange des métaux de cellules solaires (Ag, Cu, Si, Al) et à la surface la poudre composée du polymère de l'encapsulant.
[Fig.4] représente
   - gauche : Entrant de l'étape de séparation chimique des matériaux, poudre issue du procédé de délamination d'un panneau par ponçage, contenant un mélange de polymères (encapsulant, résidus de la couche arrière ou backsheet en anglais) et de métaux (Si, Ag, Cu, AI). Préférentiellement, les polymères de la couche arrière (ou backsheet en anglais) sont écartés de l'ensemble encapsulant + cellules lors de l'étape de délamination en amont de l'étape décrite dans l'invention.
   - milieu : poudre de cellules récupérée en fin de procédé contenant le Si, l'Ag, le Cu et l'AI,
   - droite : poudre de polymères récupérée en fin de procédé contenant l'EVA et les polymères de la couche arrière ou backsheet en anglais.

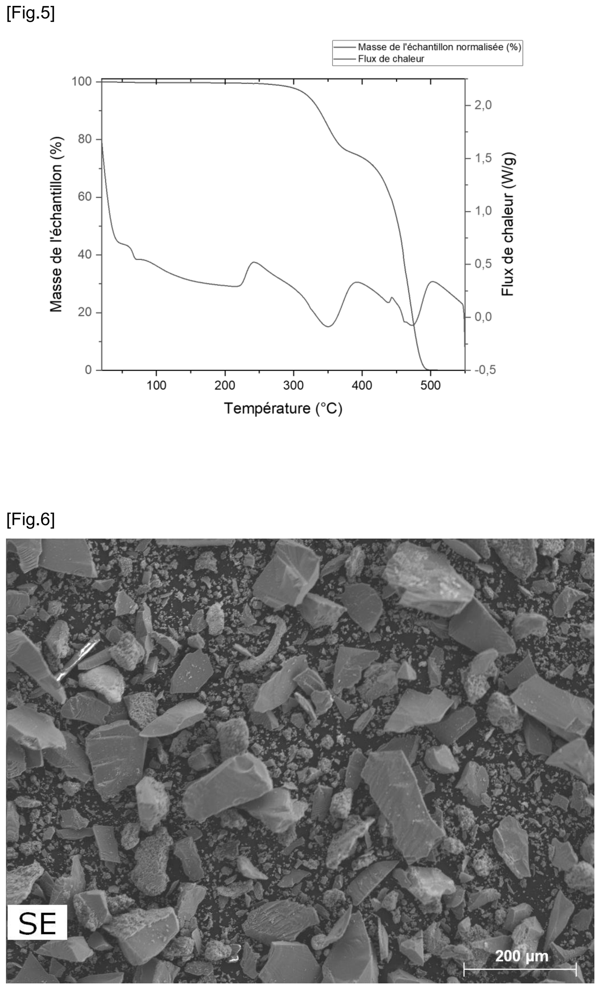

[Fig.5] est l'analyse par calorimétrie différentielle à balayage (Differential Scanning Calorimetry ou DSC, TA Instruments modèle SDT Q600) du polymère récupéré en surface du réacteur.
[Fig.6] représente l'image par microscopie électronique à balayage (MEB) (Scanning Electron Microscope ou SEM, modèle LEO 1530 de la marque Zeiss) de la poudre de cellules récupéré en fond de réacteur.

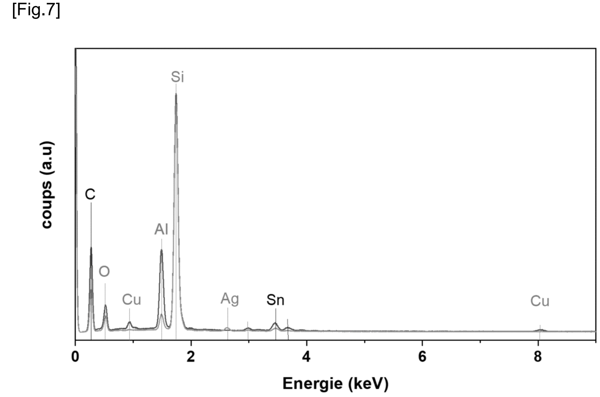

[Fig.7] représente l'analyse par spectroscopie de rayons X à dispersion d'énergie (energy-dispersive X-ray spectroscopy, EDS ou EDXS, en anglais équipant le MEB LEO 1530) de la poudre de cellules récupérée en fond de réacteur.

### Description détaillée de l'invention

La présente invention concerne un procédé de séparation des métaux des polymères de l'encapsulant d'un panneau solaire photovoltaïque, caractérisé en ce qu'il comporte les étapes suivantes :
a) Préparer un mélange de solvants dont
   - l'un des deux solvants est une solution aqueuse basique ayant un pH compris entre 8 et 14, et
   - l'autre au moins un solvant organique miscible à l'eau choisi parmi
      - les alcools primaires de formule R-CH₂OH avec R représentant un groupe alkyle comportant 1 à 4 atomes de carbone,
      - les alcools secondaires de formule R₀-CHOH-R₁ avec R₀ et R₁, identiques ou différents, représentant groupe alkyle comportant 1 à 3 atomes de carbone,
      - les diols de formule HOCH₂-(CHR₂)ₙ-CH₂OH avec n=1, 2, 3 et R₂ représentant un atome d'hydrogène ou un groupe alkyle comportant 1 à 3 atomes de carbone,
      - les diols de formule HOCH₂-(CH₂)ₘ-C(OH)R₄R₃ avec m=0 et 1 et R₃ et R₄, identiques ou différents, représentant un atome d'hydrogène, un groupe alkyle comportant 1 à 3 atomes de carbone,
      - les triols de formule HOCH₂-(CH₂)ₓ-C(OH)R₅-CH₂OH avec x= 0, 1, et R₅ représentant un atome d'hydrogène ou un groupe alkyle comportant 1 à 3 atomes de carbone,
      - les cétones de formule R₆-CO-R₇ avec R₆ et R₇, identiques ou différents, représentent un groupe alkyle comportant 1 à 3 atomes de carbone,
      - les nitriles de formule R₇-CN avec R₇ représentant un groupe alkyle comportant 1 à 3 atomes de carbone,
      et leur mélange ;
b) Ajouter les débris solides sous forme de poudre d'un panneau solaire photovoltaïque, contenant des cellules en silicium, un encapsulant polymère et potentiellement une fraction des polymères du panneau ou couche arrière polymère ou backsheet en anglais, au mélange de solvants préparé à l'étape a) ;
c) Agiter le mélange obtenu de l'étape b) à une température comprise entre 20 et 100 °C, de préférence à une température comprise entre 40 et 80 °C, par exemple 60 °C ;
d) Séparer les différents éléments une fois l'encapsulant décollé des cellules, et de la couche arrière ou backsheet en anglais.

Dans le contexte de l'invention, les termes « couche arrière » et « backsheet » en anglais, sont équivalents et parfaitement interchangeables.

On entend par « alkyle », au sens de la présente invention, un groupe carboné linéaire, ramifié, saturé, éventuellement substitué, comprenant 1 à 3 atomes de carbone, de préférence 1 à 2 atomes de carbone. A titre d'alkyle saturé, linéaire ou ramifié, on peut citer par exemple les radicaux méthyle, éthyle, propyle, et leurs isomères ramifiés lorsqu'ils sont solubles dans l'eau à hauteur de 200 g/L.

Les groupes alkyle peuvent être éventuellement substitués par un ou plusieurs atomes d'halogène choisis parmi les atomes de fluor, chlore, brome et iode; un ou plusieurs groupes nitro (-NO₂) ; un ou plusieurs groupes nitrile (-CN); un ou plusieurs groupes alkyle, avec alkyle tel que défini dans le cadre de la présente invention tant que le solvant est soluble dans l'eau à hauteur de 200 g/L.

La base utilisée dans la solution aqueuse de l'étape **a)** est choisie parmi
- les hydroxydes de métaux alcalins choisis parmi LiOH, NaOH, KOH,
- les carbonates de métaux alcalins et alcalinoterreux choisis parmi Na₂CO₃, K₂CO₃, CaCO₃, NaHCO₃, KHCO₃, CsCO₃, et leur mélange.

Dans l'étape **a),** le solvant organique est miscible à l'eau et permet de favoriser la mouillabilité du solide avec la phase aqueuse. Le solvant organique est choisi parmi
- les alcools primaires choisis parmi méthanol, éthanol, propanol et butanol, de préférence l'éthanol,
- les alcools secondaires choisis parmi l'isopropanol, le butan-2-ol, de préférence l'isopropanol,
- les diols choisis parmi l'éthylène glycol (HO-CH₂-CH₂-OH), le propylène glycol ou propane-1,2-diol (CH₃-CHOH-CH₂OH), le triméthylène glycol ou propan-1,3-diol (HOCH₂-CH₂-CH₂OH), le 2-méthylpropan-1,2-diol ((CH₃)₂C(OH)-CH₂OH), de préférence l'éthylène glycol,
- les triols choisis parmi le glycérol (HOCH₂-CH(OH)-CH₂OH), le 2-méthylpropan-1,2,3-triol (CH₂(OH)-C(OH)(CH₃)-CH₂OH), de préférence le glycérol,
- les cétones choisies parmi l'acétone, la méthyl cétone ou MEK (CH₃-CH₂-CO-CH₃), de préférence l'acétone,
- les nitriles choisis parmi l'acétonitrile, le propanenitrile, de préférence l'acétonitrile.

La concentration de la base dans la solution aqueuse de l'étape **a)** est comprise entre 0,1 M et 10 M, de préférence entre 2 M et 5 M.

Dans l'étape **a),** le rapport massique entre le solide et le(s) solvant(s) organiques dans le mélange est compris entre 1/0,5 et 1/100, de préférence entre 1/1 et 1/3.

Toujours dans l'étape **a),** le rapport solution aqueuse/solvant(s) organique(s) est entre 1/1 et 1/100, de préférence entre 1/5 et 1/10.

L'utilisation d'une solution aqueuse basique permet la bonne séparation des métaux et de l'encapsulant.

L'un des deux solvants est comme indiqué, une solution aqueuse basique à un pH compris entre 8 et 14, de préférence entre 12 et 14.

Selon un mode de réalisation, à l'étape **a)** la solution aqueuse basique est une solution de NaOH et le solvant organique est l'éthanol.

Lorsqu'un panneau solaire arrive en fin de vie, il doit être démantelé pour être recyclé.

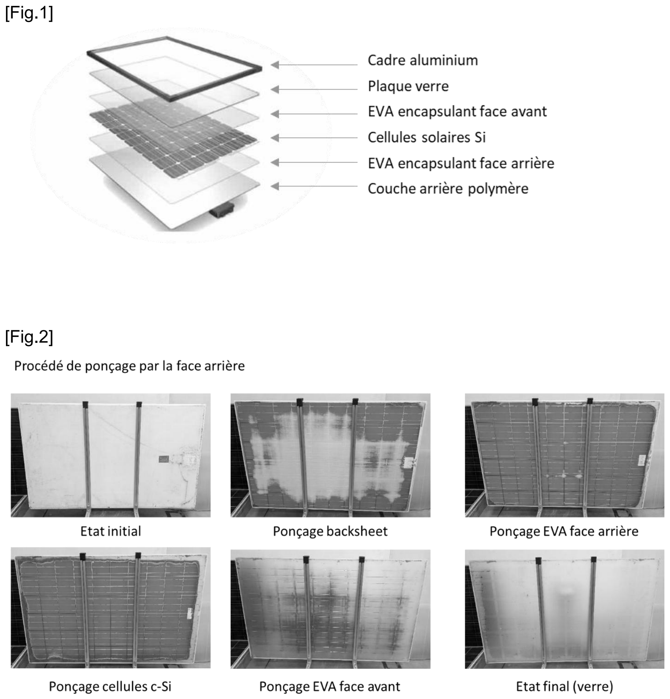

La composition d'un module photovoltaïque utilisé dans le procédé de l'invention est illustrée en [Fig.1].

Le cadre en aluminium sert à maintenir les différentes couches entre elles. Les verres utilisés sont soit des verres cristallins (mono ou polycrystallins), soit des verres à couches minces. Les verres sont parfois recouverts d'un revêtement afin de diminuer leur réflexion et à faible teneur en Fe, afin d'obtenir des valeurs de transparences élevées connues sous le nom de verre à faible teneur en fer ou verre ultra-blanc.

L'encapsulant en face avant et en face arrière des cellules solaires dans le procédé de l'invention est en poly(éthylène-acétate de vinyle) ou EVA.

La cellule photovoltaïque peut être à base de silicium, de séléniure de cuivre-indium (CuIn(Se)₂, ou CIS), de séléniure de cuivre, indium et de gallium (CuInGa(Se)₂, aussi appelé CIGS), ou de tellure de cadmium (CdTe). De préférence, la cellule photovoltaïque est à base de silicium.

La couche arrière ou backsheet en anglais est une couche protectrice supportant le tout. C'est un assemblage multicouche pouvant contenir du polyfluorure de vinylidène (PVDF), du polyethylène (PE) du poly(oxyde de *p-*phénylène) (PPO) ou poly(éther de *p*-phénylène) (PPE), poly(téréphtalate d'éthylène) (PET), chlorure de polyvinyle (PVC), ou élastomère thermoplastique (TPE) ou de l'aluminium. De préférence, il s'agit d'un assemblage PVDF/PE/PET.

La première étape, mécanique, consiste à retirer le cadre en aluminium servant à maintenir les différentes couches entre elles.

Pour un panneau solaire en fin de vie, la plaque de verre peut être soit intacte (la plaque de verre provenant d'un panneau avec une perte de rendement, d'une délamination partielle, etc.), soit brisée (intempéries, casse durant le transport de l'objet, etc.). On appelle délamination l'étape procédé de recyclage permettant de séparer le verre du reste des matériaux d'un panneau. Il existe sur le marché plusieurs voies de délamination. La méthode de délamination d'un panneau en fin de vie sera essentiellement dépendante de l'état de la plaque de verre. Dans le cas où le panneau de verre est intact, il est préférable de choisir une méthode de délamination qui conserve le verre sans le briser, afin d'éviter de la contaminer avec des métaux. Une des méthodes rencontrées dans le recyclage de panneau est la délamination par couteau chauffant. Dans cet exemple, une lame métallique chauffée à une température de 300 °C permet de séparer la plaque de verre du reste du panneau sans briser la plaque de verre. Il en sort une plaque de verre et un laminat multicouches, composé de la couche arrière ou backsheet, et des cellules solaires encapsulées sur chaque face par l'encapsulant polymère en EVA.

Une autre méthode permettant de conserver le verre sans le briser est de poncer les différentes couches de matériaux ductiles à partir de la face arrière du panneau. Cette méthode, montrée en [Fig.2] permet d'obtenir une poudre qui est un mélange des cellules solaires en silicium, de l'encapsulant EVA et de la couche arrière ou backsheet polymère. Les métaux se trouvent alors en mélange avec les polymères.

Une autre méthode permettant de conserver le verre intact est la méthode dite du fil diamanté. Le panneau est dans ce cas positionné verticalement, et une scie à fil diamanté permet de venir couper la couche d'EVA ainsi que les cellules solaires situées entre le verre et la couche arrière (backsheet en anglais). Cette méthode peut aussi être appliquée dans le cas d'un panneau bi-verre, c'est-à-dire pour les panneaux dont une plaque de verre est utilisée en face avant et en face arrière. Dans ce cas, il en sort une poudre qui est un mélange d'EVA et de cellules silicium.

Ces méthodes sont bien connues de l'homme du métier.

Pour l'étape **b),** la délamination est réalisée par la méthode du ponçage à partir de la face arrière du panneau. Les polymères constituant la couche arrière (ou backsheet en anglais) sont poncés en premier et écartés du reste des matériaux. L'ensemble encapsulant + cellules est ensuite poncé jusqu'à atteindre la plaque de verre. A l'issue de ce ponçage des débris solides sous forme de poudre du panneau photovoltaïque contenant des cellules notamment en silicium, un encapsulant polymère et potentiellement une petite fraction résiduelle de la couche arrière polymère ou backsheet en anglais) sont obtenus. Préférentiellement, les polymères de la couche arrière (ou backsheet en anglais) sont écartés de l'ensemble encapsulant + cellules lors de l'étape de délamination en amont de l'étape décrite dans l'invention. La quantité de poudre ajoutée à l'étape **b)** est comprise entre 1000 g et 2300 g par panneau.

La poudre présente une granulométrie comprise entre 100 µm et 5 mm, par exemple 500 µm.

Le rapport solide(poudre)/solvant(s) organique(s)/solution à l'étape **b)** est entre 1/1/5 et 1/10/10, de préférence entre 1/1/5 et 1/5/10.

A l'étape **c),** le mélange obtenu de l'étape **b)** est agitée à une vitesse comprise entre 70 tr/min et 500 tr/min, par exemple 240 tr/min. La température est comprise entre 20 et 100 °C, de préférence à une température comprise entre 40 et 80 °C, par exemple 60 °C.

En fin d'étape **c)** du procédé, l'agitation est arrêtée et la matière laissée à décanter. On récupère ainsi trois phases, une phase solide en fond de réacteur composée des métaux des cellules, une phase solide en surface du réacteur composée de l'encapsulant polymère et une phase liquide séparant les deux phases solides. Les différents éléments sont alors séparés à l'étape **d).** L'encapsulant polymère situé en surface du réacteur peut être isolé par débordement. Par débordement on entend l'ajout d'eau dans le système, jusqu'à ce que le réacteur déborde et entraine la couche de polymère de surface. Les métaux des cellules situés au fond du réacteur sont récupérés par vidange du réacteur. La séparation de la phase liquide de la phase solide est réalisée par filtration sous vide ou par filtration sous pression.

Dans le cas où le mélange de poudre initiale est composé de cellules solaires, de l'encapsulant en EVA et d'une fraction des polymères du backsheet, les polymères du backsheet de densité d > 1 se trouvent au fond du réacteur avec les métaux. Une purification du mélange de polymères et de métaux des cellules solaires par différences de densité est possible (étape **e)**). Après l'étape de filtration, le mélange de polymère de la couche arrière (ou backsheet en anglais) et de cellules solaires est séché. Le mélange de poudres de polymères et de cellules solaires peut ensuite être séparé par une méthode de séparation dite aérolique, permettant de séparer des poudres de densité différentes en utilisant un flux d'air. Les métaux des cellules ont des densités plus élevées que les densités des polymères. On a pour le PVDF une densité d = 1,78 ; pour le PET une densité d = 1.38 ; pour le Si une densité d = 2,33 ; pour l'Ag une densité d = 10,49 ; pour le Cu une densité d = 8.96 et pour l'Al une densité d = 2,7. Une autre méthode permettant de séparer simplement le mélange de poudres de polymères et de cellules solaires peut être réalisé par différence de densité. Dans ce cas, le mélange de poudres est placé dans une solution de densité 1,8 < d < 2,3. Dans ce cas, les polymères de densité d < 1,8 se trouveront à la surface de la solution. Les métaux d'une densité d > 2,3 se trouveront au fond de la solution. Pour obtenir une solution de densité voulue, on dissout un sel dans de l'eau pure. Le sel est choisi parmi AlCl₃, NH₄I, NH₄NO₃, (NH₄)₂HPO₄, NH₄H₂PO₄, Ca(NO₃)₂, Cu(NO₃)₂, FeCl₃, FeNO₃, MgBr₂, Ni(NO₃)₂, KC₂H₃O₂, Zn(NO₃)₂, ou tout autre sel dont la solubilité dans l'eau permet d'atteindre des solutions de densité voulue.

Le principe du procédé de l'invention repose sur la séparation physique des différents matériaux constitutifs du panneau photovoltaïque, en utilisant leur densité. L'invention se différencie essentiellement des voies de séparation chimique classiquement rencontrées par le fait qu'elle repose sur un mélange de solvants, constitué d'une phase organique et d'une phase aqueuse basique. Les deux phases sont miscibles, c'est-à-dire que l'association du solvant organique et de la phase aqueuse forment une seule phase.

L'ajout du mélange de déchets provenant d'un panneau solaire (polymères + métaux) constituera une phase supplémentaire solide. La séparation des polymères et des métaux est garantie par leur différence de densité. Les métaux et polymères d'une densité d > 1 décanteront au fond du système multiphasique alors que les polymères de densité d < 1 monteront à la surface de la phase liquide.

Les principaux métaux utilisés dans les panneaux solaires sont l'aluminium, l'acier, le cuivre, l'argent et le zinc. L'aluminium ou l'acier composent souvent les supports et le système de support. Parfois, l'aluminium fournit également le câblage. Le cuivre peut constituer le câblage du panneau solaire. L'invention a également pour objet l'utilisation d'un procédé selon l'invention pour le recyclage des panneaux solaires photovoltaïques.

### EXEMPLES

L'éthanol a été acheté chez Carlo Erba, l'hydroxyde de sodium (pureté 98-100 %) a été acheté chez Sigma Aldrich. Le mélange de poudres contenant de l'encapsulant et des cellules uniquement a été obtenu par ponçage d'un panneau TRINA Solar en fin de vie. La poudre a été tamisée avant l'essai à une granulométrie de 300 µm.

### Exemple 1 : Séparation des matériaux provenant de la délamination par procédé de ponçage à partir de la face arrière d'un panneau.

Le ponçage d'un panneau par la face arrière va générer des poudres enrichies en matériaux des différentes couches. Dans le procédé ici décrit, la poudre traitée sera un concentré de l'EVA des faces avant et arrière, et des cellules solaires c-Si. Il peut exister une pollution du milieu par un peu de backsheet polymère, essentiellement composé de polymère fluoré de densité d > 1. Les différentes étapes de ponçage d'un panneau solaire à partir de la face arrière constituée de couche arrière ou backsheet polymère est montré en [Fig.2].

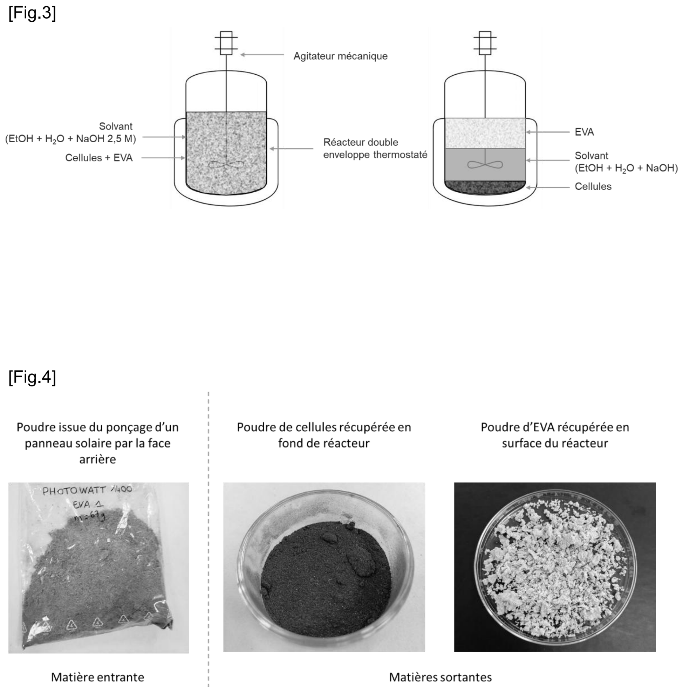

Dans cet exemple, la séparation est réalisée dans un mélange d'éthanol et d'eau. Dans ce mélange est dissous de l'hydroxyde de sodium NaOH à une concentration de 2 M. Le rapport poudre/éthanol/eau est de 1/1/5 en masse. L'ensemble est placé dans un réacteur à double enveloppe chauffé à 60 °C puis agité à 240 tr/min. pendant 24 h. A la fin de l'étape de séparation chimique des matériaux, l'agitation est arrêtée et la matière laissée à décanter. On récupère ainsi trois phases, une phase solide en fond de réacteur composée des métaux des cellules, une phase solide en surface du réacteur composée de l'encapsulant polymère et une phase liquide séparant les deux phases solides comme montré en [Fig.3].

L'encapsulant polymère de densité d < 1 est récoltée par débordement. Par débordement on entend l'ajout d'eau dans le réacteur jusqu'à ce que la phase surnageante soit écartée du réacteur. Le polymère ainsi récolté est lavé à l'eau puis séché à 60 °C dans une étuve ventilée.

Le réacteur peut ensuite être vidangé. La poudre de métaux peut ensuite être isolée de la phase liquide par filtration sous vide ou sous pression, en utilisant un filtre de granulométrie comprise entre 5 µm et 200 µm, par exemple 10 µm.

## Revendications

1. Procédé de séparation des métaux des polymères de l'encapsulant d'un panneau solaire photovoltaïque, **caractérisé en ce qu'**il comporte les étapes suivantes :
**a)** Préparer un mélange de solvants dont
- l'un des deux solvants est une solution aqueuse basique ayant un pH compris entre 8 et 14, et
- l'autre au moins un solvant organique miscible à l'eau choisi parmi
- les alcools primaires de formule R-CH₂OH avec R représentant un groupe alkyle comportant 1 à 4 atomes de carbone,
- les alcools secondaires de formule R₀-CHOH-R₁ avec R₀ et R₁, identiques ou différents, représentant groupe alkyle comportant 1 à 3 atomes de carbone,
- les diols de formule HOCH₂-(CHR₂)ₙ-CH₂OH avec n=1, 2, 3 et R₂ représentant un atome d'hydrogène ou un groupe alkyle comportant 1 à 3 atomes de carbone,
- les diols de formule HOCH₂-(CH₂)ₘ-C(OH)R₄R₃ avec m=0 et 1 et R₃ et R₄, identiques ou différents, représentant un atome d'hydrogène, un groupe alkyle comportant 1 à 3 atomes de carbone,
- les triols de formule HOCH₂-(CH₂)ₓ-C(OH)R₅-CH₂OH avec x= 0, 1, et R₅ représentant un atome d'hydrogène ou un groupe alkyle comportant 1 à 3 atomes de carbone,
- les cétones de formule R₆-CO-R₇ avec R₆ et R₇, identiques ou différents, représentent un groupe alkyle comportant 1 à 3 atomes de carbone,
- les nitriles de formule R₇-CN avec R₇ représentant un groupe alkyle comportant 1 à 3 atomes de carbone,
et leur mélange ;
**b)** Ajouter les débris solides sous forme de poudre d'un panneau solaire photovoltaïque, contenant des cellules en silicium, un encapsulant polymère et potentiellement une fraction des polymères du panneau ou couche arrière polymère ou backsheet en anglais, au mélange de solvants préparé à l'étape **a)** ;
**c)** Agiter le mélange obtenu de l'étape **b)** à une température comprise entre 20 et 100 °C, de préférence à une température comprise entre 40 et 80°C, par exemple 60 °C ;
**d)** Séparer les différents éléments une fois l'encapsulant décollé des cellules, et de la couche arrière ou backsheet en anglais.

2. Procédé selon la revendication 1, **caractérisé en ce que** la base utilisée dans la solution aqueuse de l'étape **a)** est choisie parmi
- les hydroxydes de métaux alcalins choisis parmi LiOH, NaOH, KOH,
- les carbonates de métaux alcalins et alcalinoterreux choisis parmi Na₂CO₃, K₂CO₃, CaCO₃, NaHCO₃, KHCO₃, CsCO₃, et leur mélange.

3. Procédé selon l'une des revendications 1 ou 2, **caractérisé en ce que** dans l'étape **a),** le solvant organique est choisi parmi
- les alcools primaires choisis parmi méthanol, éthanol, propanol et butanol, de préférence l'éthanol,
- les alcools secondaires choisis parmi l'isopropanol, le butan-2-ol, de préférence l'isopropanol,
- les diols choisis parmi l'éthylène glycol (HO-CH₂-CH₂-OH), le propylène glycol ou propan-1,2-diol (CH₃-CHOH-CH₂OH), le triméthylène glycol ou propan-1,3-diol (HOCH₂-CH₂-CH₂OH), le 2-méthylpropan-1,2-diol ((CH₃)₂C(OH)-CH₂OH), de préférence l'éthylène glycol,
- les triols choisis parmi le glycérol (HOCH₂-CH(OH)-CH₂OH), le 2-méthylpropan-1,2,3-triol (CH₂(OH)-C(OH)(CH₃)-CH₂OH), de préférence le glycérol,
- les cétones choisies parmi l'acétone, la méthyl cétone ou MEK (CH₃-CH₂-CO-CH₃), de préférence l'acétone,
- les nitriles choisis parmi l'acétonitrile, le propanenitrile, de préférence l'acétonitrile.

4. Procédé selon l'une quelconque des revendications 1 à 3, **caractérisé en ce que** la concentration de la base dans la solution aqueuse de l'étape **a)** est comprise entre 0,1 M et 10 M, de préférence entre 2 M et 5 M.

5. Procédé selon l'une quelconque des revendications 1 à 4, **caractérisé en ce que** dans l'étape **a),** le rapport massique entre le solide et le(s) solvant(s) organiques dans le mélange est compris entre 1/0,5 et 1/100, de préférence entre 1/1 et 1/3.

6. Procédé selon l'une quelconque des revendications 1 à 5, **caractérisé en ce que** dans l'étape **a),** le rapport solution aqueuse/solvant(s) organique(s) est entre 1/1 et 1/100, de préférence entre 1/5 et 1/10.

7. Procédé selon l'une quelconque des revendications 1 à 6, **caractérisé en ce que** la quantité de poudre ajouté à l'étape **b)** est de 1000 g à 2300 g par panneau.

8. Procédé selon l'une quelconque des revendications 1 à 7, **caractérisé en ce que** le rapport solide(poudre)/solvant(s) organique(s)/solution à l'étape **b)** est entre 1/1/5 et 1/10/10, de préférence entre 1/1/5 et 1/5/10.

9. Utilisation d'un procédé selon l'une quelconque des revendications 1 à 8 pour le recyclage des panneaux solaires photovoltaïques.
